(19) Europäisches Patentamt
European Patent Office
Office européen des brevets

(11) **EP 4 788 105 A1**

(12) **EUROPEAN PATENT APPLICATION**
published in accordance with Art. 153(4) EPC

(43) Date of publication:
**05.08.2026 Bulletin 2026/32**

(21) Application number: **24872843.8**

(22) Date of filing: **23.09.2024**

(51) International Patent Classification (IPC):
***H10K 59/38*** *(2023.01)* ***H10K 59/35*** *(2023.01)*
***H10K 77/10*** *(2023.01)* ***H10K 59/90*** *(2026.01)*

(52) Cooperative Patent Classification (CPC):
**C09K 11/0883; C09K 11/025; C09K 11/621; C09K 11/883; H10K 59/38;** B82Y 20/00; B82Y 40/00

(86) International application number:
**PCT/KR2024/014318**

(87) International publication number:
**WO 2025/071135 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.09.2023 KR 20230128631**

(71) Applicant: **Samsung Display Co., Ltd.**
**Yongin-si, Gyeonggi-do 17113 (KR)**

(72) Inventors:
- **LEE, Kyung Sig**
  **Yongin-si, Gyeonggi-do 17113 (KR)**
- **NAM, Ju O**
  **Yongin-si, Gyeonggi-do 17113 (KR)**
- **PAK, Ka Won**
  **Yongin-si, Gyeonggi-do 17113 (KR)**
- **PARK, Seung Won**
  **Yongin-si, Gyeonggi-do 17113 (KR)**
- **LEE, Taek Joon**
  **Yongin-si, Gyeonggi-do 17113 (KR)**
- **JANG, Seung Hee**
  **Yongin-si, Gyeonggi-do 17113 (KR)**
- **CHANG, Jae Bok**
  **Yongin-si, Gyeonggi-do 17113 (KR)**

(74) Representative: **Marks & Clerk LLP**
**15 Fetter Lane**
**London EC4A 1BW (GB)**

(54) **DISPLAY DEVICE AND ELECTRONIC DEVICE COMPRISING SAME**

(57) A display device includes a light emitting element on a substrate and that generates light of a preset color and a color conversion layer on the light emitting element and including a first quantum dot that exhibits a first absorption peak in a UV-vis absorption spectrum and a second quantum dot that is different from the first quantum dot and does not exhibit a first absorption peak in a UV-vis absorption spectrum.

FIG. 2

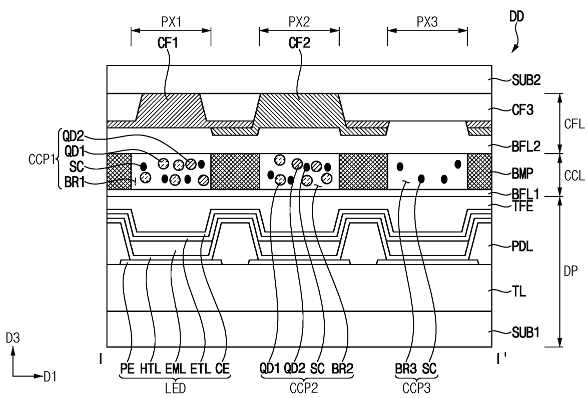


EP 4 788 105 A1

## Description

### [Technical Field]

Embodiments of the present invention relate to a display device and an electronic device including the same. For example, embodiments of the present invention relate to a display device that provides visual information and an electronic device including the same.

### [Description of the Related Art]

Various electronic devices are being developed to provide image information in multimedia devices such as monitors, televisions, mobile phones, tablet computers, navigation devices, game consoles, etc. For example, quantum dots are being introduced to improve display quality in electronic devices including liquid crystal display devices and organic electroluminescent display devices.

Additionally, in order to ensure that these electronic devices exhibit good display quality and excellent reliability characteristics, methods for improving the reliability of light functional layers including quantum dots are being studied.

### [Detailed Explanation of the Invention]

### [Technical Purpose]

One purpose of the present invention is to provide a display device having improved display quality.

Another purpose of the present invention is to provide an electronic device having improved display quality.

However, the purpose of the present invention is not limited thereto, and various modifications may be made without departing from the spirit and scope of the present invention.

### [Technical Solution]

A display device according to an embodiment of the present invention may include a light-emitting element on a substrate and that generates light of a preset color, and a color conversion layer on the light-emitting element and including a first quantum dot that exhibits a first absorption peak in a UV-vis absorption spectrum and a second quantum dot different from the first quantum dot and that does not exhibit a first absorption peak in a UV-vis absorption spectrum.

In an embodiment, a weight ratio of the first quantum dot to the second quantum dot may be about 1.5:1 to about 2.5:1.

In an embodiment, the first quantum dot may include a first core including indium (In) and phosphorus (P).

In an embodiment, the first quantum dot may further include a first shell surrounding the first core, and the first shell may include at least one selected from the group consisting of zinc (Zn), selenium (Se), and sulfur (S).

In an embodiment, the second quantum dot may include a second core including silver (Ag), indium (In), gallium (Ga), and sulfur (S).

In an embodiment, the second quantum dot may further include a second shell surrounding the second core, and the second shell may include gallium (Ga) and sulfur (S).

In an embodiment, a valley depth of the first quantum dot satisfying Equation 1 below may include a value greater than about 0 and less than about 1:

Equation 1

$$1 - (Abs_{valley}/Abs_{first}) = \text{valley depth}.$$

In Equation 1, $Abs_{first}$ is an absorption at the first absorption peak, and $Abs_{valley}$ is an absorption at a lowest point of a valley adjacent to the first absorption peak.

In an embodiment, a first radius of the first quantum dot may be smaller than an exciton Bohr radius of the first quantum dot.

In an embodiment, a second radius of the second quantum dot may be larger than an exciton Bohr radius of the second quantum dot.

In an embodiment, a maximum emission wavelength of a PL (photoluminescence) spectrum of the first quantum dot may be about 495 nm to about 535 nm.

In an embodiment, a maximum emission wavelength of a PL spectrum of the second quantum dot may be about 515 nm to about 545 nm.

In an embodiment, a maximum emission wavelength of a PL spectrum of the color conversion layer may be about 511 nm to about 541 nm.

In an embodiment, each of the first quantum dot and the second quantum dot may include a first ligand and a second ligand different from the first ligand.

In an embodiment, the first ligand may include a compound including a thiol group and polyethylene glycol.

In an embodiment, the second ligand may include a compound including carboxylate (e.g., a carboxylate group) and acrylic (e.g., an acrylic group).

In an embodiment, a weight ratio of the first ligand to the second ligand may be about 1.5:1 to about 4:1.

In an embodiment, a weight ratio of a sum of the weights of the first quantum dot and the second quantum dot to a sum of the weights of the first ligand and the second ligand may be about 1.5:1 to about 5:1.

An electronic device according to embodiments of the present invention may include a display device including a substrate including a first pixel area, a second pixel area, and a third pixel area that respectively emit light of different colors, a light emitting element provided in each of the first, the second, and third pixel areas on the substrate and that generates a preset light, a first light control portion provided in the first pixel area on the light emitting element and including a first quantum dot that exhibits a first absorption peak in a UV-vis absorption spectrum and a second quantum dot that does not exhibit a first absorption peak in a UV-vis absorption spectrum, a second light control portion provided in the second pixel area on the light emitting element and including a same material as the first light control portion, and a third light control portion provided in the third pixel area on the light emitting element, and a power supply module that supplies power to the display device.

In an embodiment, a weight ratio of the first quantum dot to the second quantum dot may be about 1.5:1 to about 2.5:1.

In an embodiment, the first quantum dot may include a first core including indium (In) and phosphorus (P), and the second quantum dot may include a second core including silver (Ag), indium (In), gallium (Ga), and sulfur (S).

## [Advantageous Effects]

A display device according to an embodiment of the present invention may include a light-emitting element on a substrate and that generates light of a preset color, and a color conversion layer on the light-emitting element and including a first quantum dot that exhibits a first absorption peak in a UV-vis absorption spectrum and a second quantum dot different from the first quantum dot and that does not exhibit a first absorption peak in a UV-vis absorption spectrum.

Accordingly, an area of a portion in which the UV-vis absorption spectrum of the color conversion layer overlaps with a PL spectrum thereof (i.e., a valley depth area) may be minimized. In this case, a decrease in external emission efficiency of the display device may be minimized.

However, the effects of the present invention are not limited to the above-mentioned effects, and can be variously extended within the spirit and scope of the present invention.

## [Brief Description of the Drawings]

FIG. 1 is a plan view showing a display device according to an embodiment of the present invention.
FIG. 2 is a cross-sectional view taken along line I-I' of the display device of FIG. 1.
FIG. 3 is an enlarged cross-sectional view of an example of a light control portion of FIG. 2.
FIG. 4 is an enlarged cross-sectional view showing an example of the quantum dot shown in FIG. 3.
FIG. 5 is a graph showing an example of a UV-vis absorption spectrum of each of first and second quantum dots of FIG. 3.
FIG. 6 is a graph showing an example of a PL spectrum of each of the first and second quantum dots of FIG. 3.
FIG. 7 is a graph showing an example of a UV-vis absorption spectrum and a PL spectrum of each of the first quantum dot, the second quantum dot, and a mixture of the first and second quantum dots of FIG. 3.
FIG. 8 is a graph for explaining a valley depth in a UV-vis absorption spectrum of each quantum dot of FIG. 3.

## [Best Mode for Carrying Out the Invention]

Hereinafter, embodiments will be described in detail with reference to the accompanying drawings. The same reference numerals are used for the same components in the drawings, and redundant descriptions of the same components will be omitted.

In this specification, a plane may be defined by a first direction D1 and a second direction D2 intersecting the first direction D1. For example, the second direction D2 may be perpendicular to the first direction D1. In one or more

embodiments, a third direction D3 may be the normal direction of a plane. In one or more embodiments, the third direction D3 may be perpendicular to the plane formed by the first direction D1 and the second direction D2.

FIG. 1 is a plan view showing a display device according to an embodiment of the present invention.

Referring to FIG. 1, the display device DD may include a display area DA and a peripheral area SA. The display area DA may be surrounded by the peripheral area SA.

The display area DA may be an area that displays an image by generating light or adjusting the transmittance of light provided from an external light source. The peripheral area SA may be an area that does not display an image. However, embodiments of the present invention are not limited thereto, and at least a portion of the peripheral area SA may display an image.

A plurality of pixel areas PX that generate an image may be provided in the display area DA. The image may be generated by combining light emitted from each of the pixel areas PX. For example, the pixel areas PX may be provided in a matrix form along the first direction D1 and the second direction D2 intersecting the first direction D1.

In one or more embodiments, the display area DA may include a first pixel area PX1, a second pixel area PX2, and a third pixel area PX3. For example, the first pixel area PX1 may emit red light. The second pixel area PX2 may emit green light. The third pixel area PX3 may emit blue light. However, embodiments of the present invention are not limited thereto. The first, the second, and the third pixel areas PX1, PX2, and PX3 may emit light that is a combination of red, green, and blue light.

In one or more embodiments, the peripheral area SA may include a power supply module that supplies power to the display device DD.

FIG. 2 is a cross-sectional view taken along line I-I' of the display device of FIG. 1. FIG. 3 is an enlarged cross-sectional view of an example of the light control portion of FIG. 2.

Referring to FIGS. 2 and 3, the display device DD may include a display panel DP, a color conversion layer CCL, a color filter layer CFL, and a second substrate SUB2.

The display panel DP may include a first substrate SUB1, a transistor layer TL, light emitting elements LED, a pixel defining layer PDL, and a thin film encapsulation layer TFE.

The first substrate SUB1 may be a glass substrate, a metal substrate, and/or a plastic substrate. However, embodiments of the present invention are not limited thereto, and the first substrate SUB1 may be an inorganic layer, an organic layer, or a composite material layer.

The transistor layer TL may be on the first substrate SUB1 and may include a plurality of transistors. The transistors may each include a control electrode, an input electrode, and an output electrode. For example, the transistor layer TL may include a switching transistor and a driving transistor for driving the light emitting elements LED of the display panel DP.

The light emitting elements LED may be provided in each of the first, the second, and the third pixel areas PX1, PX2, and PX3.

Each of the light emitting elements LED may include a pixel electrode PE, a hole transport area HTL, an emission layer EML, an electron transport area ETR, and a second electrode CE. The hole transport area HTL, the light emitting layer EML, the electron transport area ETL, and the second electrode CE may be provided as a common layer throughout the light emitting elements LED. Each of the light-emitting elements LED may emit light of a first color in a single wavelength range. For example, the first color light emitted by each of the light emitting elements LED may be blue light.

The pixel defining layer PDL may be on the pixel electrode PE. For example, the pixel defining layer PDL may expose at least a portion of the pixel electrode PE. The pixel defining layer PDL may include an inorganic insulating material (e.g., an inorganic electrically insulating material) or an organic insulating material (e.g., an organic electrically insulating material).

The thin film encapsulation layer TFE may cover the light emitting elements LED. The thin film encapsulation layer TFE may seal the display panel DP. The thin film encapsulation layer TFE may include one layer or a plurality of layers. In one or more embodiments, the thin film encapsulation layer TFE may include at least one insulating layer (e.g., at least one electrically insulating layer).

For example, the thin film encapsulation layer TFE may include at least one inorganic encapsulation layer and at least one organic encapsulation layer.

The inorganic encapsulation layer may protect the display panel DP from moisture/oxygen, and the organic encapsulation layer may protect the display panel DP from foreign substances such as dust particles. The inorganic encapsulation layer may include at least one selected from silicon nitride, silicon oxy nitride, silicon oxide, titanium oxide, aluminium oxide, etc. The organic encapsulation layer may include at least one selected from acrylic compound, an epoxy compound, and a photopolymerizable organic material. These may be used alone or in combination with each other. However, embodiments of the present invention are not limited thereto.

The color conversion layer CCL may be on the display panel DP. The color conversion layer CCL may include a first barrier layer BFL1, a plurality of light control portions CCP1, CCP2, and CCP3, and a division pattern BMP. The color conversion layer CCL may include a light converter. The light converter may be a quantum dot QD, etc. The light converter

may convert the received light into wavelengths and emit it. For example, the color conversion layer CCL may be a layer including the quantum dot QD.

The first barrier layer BFL1 may be under the light control portions CCP1, CCP2, and CCP3 in a cross-sectional view. The first barrier layer BFL1 may block or reduce exposure of the light control portions CCP1, CCP2, and CCP3 to moisture/oxygen.

The first barrier layer BFL1 may include at least one inorganic layer. For example, the first barrier layer BFL1 may include a silicon compound and/or metal oxide. Examples of the silicon compound may include silicon nitride, silicon oxynitride, etc. Examples of the metal oxide may include aluminium nitride, zirconium nitride, titanium nitride, hafnium nitride, tantalum nitride, silicon oxide, aluminium oxide, titanium oxide, tin oxide, cerium oxide, etc. These may be used alone or in combination with each other.

In one or more embodiments, the first barrier layer BFL1 may further include an organic layer. The first barrier layer BFL1 may be composed of a single layer or a plurality of layers.

The light control portions CCP1, CCP2, and CCP3 may be on the first barrier layer BFL1. For example, the first light control portion CCP1 may be provided in the first pixel area PX1, and the second light control portion CCP2 may be provided in the second pixel area PX2, and the third light control portion CCP3 may be provided in the third pixel area PX3.

As shown in FIG. 2, the division pattern BMP may be between the light control portions CCP1, CCP2, and CCP3, but embodiments of the present invention are not limited thereto. In FIG. 2, the division pattern BMP is shown as non-overlapping with the light control portions CCP1, CCP2, and CCP3, but at least a portion of the light control portions CCP1, CCP2, and CCP3 may overlap at least a portion of the division pattern BMP.

In one or more embodiments, the thickness W of each of the light control portions CCP1, CCP2, and CCP3 in the third direction D3 may be about 7 $\mu$m to about 10 $\mu$m. However, embodiments of the present invention are not limited thereto.

In one or more embodiments, the first light control portion CCP1 may include the quantum dot QD, a scatterer SC (e.g., a light scatterer), and a first base resin BR1. For example, the quantum dot QD may include a first quantum dot QD1 and a second quantum dot QD2.

The first quantum dot QD1 may convert a first color light into a second color light. The first color light may be light emitted from the light emitting elements LED. For example, the first color light may be blue light. The second quantum dot QD2 may convert the first color light into a third color light. Accordingly, the first light control portion CCP1 may convert the first color light into a fourth color light. For example, the fourth color light may be red light. However, embodiments of the present invention are not limited thereto.

In one or more embodiments, the first color light may include a wavelength range of about 450 nm to about 460 nm. The second color light may include a wavelength range of about 495 nm to about 535 nm. The third color light may include a wavelength range of about 515 nm to about 545 nm. The fourth color light may include a wavelength range of about 511 nm to about 541 nm.

In one or more embodiments, a weight ratio of the first quantum dot QD1 and the second quantum dot QD2 may be about 2:1. For example, a weight ratio of the first quantum dot QD1 and the second quantum dot QD2 may be about 1.5:1 to about 2.5:1. In one or more embodiments, a weight ratio of the first quantum dot QD1 and the second quantum dot QD2 may be about 2:1 to about 2.5:1. However, embodiments of the present invention are not limited thereto.

The scatterer SC may increase the efficiency of the first light control portion CCP1 by scattering the incident light of the first color in various suitable directions. The scatterer SC may be an inorganic particle. For example, the scatterer SC may include at least one selected from $TiO_2$, ZnO, $Al_2O_3$, $SiO_2$, and hollow silica. These may be used alone or in combination with each other.

The first base resin BR1 may be a medium in which the first quantum dot QD1, the second quantum dot QD2, and the scatterer SC may be dispersed, and may include various suitable resin compositions that may generally be referred to as binders. For example, the first base resin BR1 may include at least one selected from acrylic resin, urethane resin, silicone resin, and epoxy resin. These may be used alone or in combination with each other. The first base resin BR1 may be a transparent resin.

The second light control portion CCP2 may include the first quantum dot QD1, the second quantum dot QD2, the scatterer SC, and the second base resin BR2. Descriptions overlapping with those of the first light control portion CCP1 may be omitted or simplified.

The second base resin BR2 may be a medium in which the first quantum dot QD1, the second quantum dot QD2, and the scatterer SC may be dispersed, and may include various suitable resin compositions that may generally be referred to as binders. The second base resin BR2 may include substantially the same material as the first base resin BR1.

The third light control portion CCP3 may include the scatterer SC and a third base resin BR3. The third light control portion CCP3 may be substantially the same as the first and second light control portions CCP1 and CCP2 except that it does not include the quantum dots QD. Therefore, overlapping explanations may be omitted or simplified.

The third base resin BR3 may be a medium in which the scatterer SC may be dispersed, and may include various suitable resin compositions that may generally be referred to as binders. The third base resin BR3 may include

substantially the same material as the first base resin BR1 and the second base resin BR2.

The color filter layer CFL may be on the color conversion layer CCL. The color filter layer CFL may include a second barrier layer BFL2 and color filters CF1, CF2, and CF3.

The second barrier layer BFL2 may be on the color conversion layer CCL. The second barrier layer BFL2 may prevent or reduce penetration of moisture and/or oxygen. The second barrier layer BFL2 may block or reduce exposure of the light control portions CCP1, CCP2, and CCP3 to moisture and/or oxygen. The second barrier layer BFL2 may cover the light control portions CCP1, CCP2, and CCP3.

The color filters CF1, CF2, and CF3 may be on the second barrier layer BFL2.

For example, the first color filter CF1 may be a red filter, the second color filter CF2 may be a green filter, and the third color filter CF3 may be a blue filter. Each of the color filters CF1, CF2, and CF3 may include a polymer photosensitive resin, a pigment, and/or dye. The first color filter CF1 may include a red pigment and/or dye, the second color filter CF2 may include a green pigment and/or dye, and the third color filter CF3 may include a blue pigment and/or dye.

However, embodiments of the present invention are not limited thereto. The third color filter CF3 may not include a pigment or dye. The third color filter CF3 may include polymer photo resin and may not include a pigment or dye. In one or more embodiments, the third color filter CF3 may be transparent. The third color filter CF3 may be formed of transparent photo resin.

In one or more embodiments, the first color filter CF1 and the second color filter CF2 may be a yellow color filter or a color filter combining red, green, and blue. The first color filter CF1 and the second color filter CF2 may not be separated from each other and may be provided as one portion.

The second substrate SUB2 may be on the color filter layer CFL. The second substrate SUB2 may be a member that provides a base surface on which the color filter layer CFL and the color conversion layer CCL are provided. The second substrate SUB2 may include a glass substrate, a metal substrate, and/or a plastic substrate. However, embodiments of the present invention are not limited thereto, and the second substrate SUB2 may be an inorganic layer, an organic layer, or a composite material layer. In one or more embodiments, the second substrate SUB2 may be omitted.

FIG. 4 is an enlarged cross-sectional view showing an example of the quantum dot shown in FIG. 3.

Referring to FIG. 4, the quantum dot QD may include a core CR, a first stable layer STL1, a shell SH, a second stable layer STL2, and a ligand LD. In one or more embodiments, the core CR may include a first core CR1 and a second core CR2. The shell SH may include a first shell SH1 and a second shell SH2. The ligand LD may include a first ligand LD1 and a second ligand LD2.

For example, the quantum dot QD in FIGS. 3 and 4 may include the first quantum dot QD1 and the second quantum dot QD2. The first quantum dot QD1 may include the first core CR1, the first stable layer STL1, the first shell SH1, the second stable layer STL2, the first ligand LD1, and the second ligand LD2, and the second quantum dot QD2 may include the second core CR2, the first stable layer STL1, the second shell SH2, and the second stable layer STL2, the first ligand LD1, and the second ligand LD2.

The diameter of the core CR may be about 1 nm to about 10 nm. When the diameter of the core CR satisfies the above-mentioned range, the light efficiency of the quantum dot QD may be excellent. In one or more embodiments, the diameter of the core CR may be about 1.2 nm to about 5 nm.

In one or more embodiments, the first core CR1 may include indium (In), phosphorus (P), etc. In one or more embodiments, examples of materials that are included in the first core CR1 may be group II-VI semiconductor compounds, group III-V semiconductor compounds, or any combination thereof.

For example, examples of the II-VI group semiconductor compounds include binary compounds such as CdS, CdSe, CdTe, ZnS, ZnSe, ZnTe, ZnO, HgS, HgSe, HgTe, MgSe, MgS, etc.; ternary compounds such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, etc.; and quaternary compounds such as CdZnSeS, CdZnSeTe, CdZnSTe, CdHgSeS, CdHgSeTe, CdHgSTe, HgZnSeS, HgZnSeTe, HgZnSTe, etc. These may be used alone or in combination with each other.

In an example, examples of materials included in a group III-V semiconductor compound include binary compounds such as GaN, GaP, GaAs, GaSb, AlN, AlP, AlAs, AlSb, InN, InAs, InSb, etc.; ternary compounds such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, etc.; quaternary compounds such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, etc. In one or more embodiments, a group III-V semiconductor compound may further include a group II element. Examples of group III-V semiconductor compounds further including group II elements may include InZnP, InGaZnP, InAlZnP, etc. These may be used alone or in combination with each other.

In one or more embodiments, the second core CR2 may include silver (Ag), indium (In), gallium (Ga), and sulfur (S). In one or more embodiments, the second core CR2 may include a group I-III-VI compound.

For example, the second core CR2 may include at least one selected from AgInGaS, AgInS, $AgInS_2$, CuInS, $CuInS_2$, $CuInGaS_2$, $AgGaS_2$, $CuGaS_2$, $CuGaO_2$, $AgGaO_2$, and $AgAlO_2$.

The shell SH may surround the core CR. The thickness W of the shell SH may be about 0.5 nm to about 10 nm. Within the above range, the stability of the quantum dot QD may be excellent. The shell SH may serve as a protective layer to maintain semiconductor properties by preventing or reducing chemical denaturation of the core CR of the quantum dot QD and/or a charging layer to impart electrophoretic properties to the quantum dot QD. The shell SH of the quantum dot QD may be a single layer or a multi-layer.

In one or more embodiments, the first shell SH1 may include ZnS and/or ZnSeS. In one or more embodiments, examples of materials that are included in the first shell SH1 include CdS, CdSe, CdTe, ZnSe, ZnTe, ZnTeS, GaAs, GaP, GaS, GaSb, HgS, HgSe, HgTe, InAs, InP, InGaP, InSb, AlAs, AlP, AlSb, etc. These may be used alone or in combination with each other. However, embodiments of the present invention are not limited thereto.

In one or more embodiments, the second shell SH2 may include GaS. Examples of materials that are included in the second shell SH2 include CdS, CdSe, CdTe, ZnS, ZnSe, ZnTe, ZnSeS, ZnTeS, GaAs, GaP, GaSb, HgS, HgSe, HgTe, InAs, InP, InGaP, InSb. AlAs, AlP, AlSb, etc. These may be used alone or in combination with each other. However, embodiments of the present invention are not limited thereto.

As shown in FIG. 4, the quantum dot QD may include the first stable layer STL1 between the core CR and the shell SH. In one or more embodiments, the quantum dot QD may further include the second stable layer STL2 surrounding the shell SH.

The first stable layer STL1 is a layer that mediates the core CR and the shell SH, improves the bonding strength of the core CR and the shell SH, and the stability and reliability of the quantum dot QD may be increased by preventing or reducing the occurrence of defects and/or cracks inside the shell SH. The first stable layer STL1 may include one or more selected from cadmium (Cd), selenium (Se), zinc (Zn), and sulfur (S). However, embodiments of the present invention are not limited thereto.

As the second stable layer STL2 is a layer that mediates the shell SH and the ligand LD, stability and reliability of the quantum dot QD may be increased by improving a binding force between the shell SH and the ligand LD, and preventing or reducing occurrence or likelihood defects of the core-shell. The second stable layer STL2 may include one or more selected from cadmium (Cd), selenium (Se), zinc (Zn), and sulfur (S). However, embodiments of the present invention are not limited thereto.

However, the first stable layer STL1 and/or the second stable layer STL2 may be omitted. For example, the first stable layer STL1 may be omitted on the core CR and the shell SH may be provided directly on the core CR, and the second stable layer STL2 may be omitted on the shell SH The quantum dot QD may be defined.

In one or more embodiments, the first radius r1 of the first quantum dot QD1 may be about 2 nm to about 4 nm. For example, the first radius r1 of the first quantum dot QD1 may be about 2.5 nm to about 3.5 nm. In one or more embodiments, the second radius r2 of the second quantum dot QD2 may be about 2 nm to about 4 nm.

In one or more embodiments, the first radius r1 may be smaller than an exciton Bohr radius of the first quantum dot QD1. The second radius r2 may be larger than an exciton Bohr radius of the second quantum dot QD2. When a radius of the quantum dot QD is smaller than an exciton Bohr radius, the quantum dot QD has the characteristic of absorbing and emitting a single photon like the quantum dot QD of a general semiconductor.

The quantum dot QD may include the ligand LD at the outermost part. The quantum dot QD may exhibit physical properties according to the ligand LD and have excellent dispersion power.

In one or more embodiments, the first ligand LD1 may be $m(PEG)_4$-SH including a thiol group and polyethylene glycol. For example, the first ligand LD1 may include a compound represented by Formula 1 below.

For example, examples of substances that are included in the first ligand LD1 may include $m(PEG)_4$-SH, butanethiol, pentanethiol, hexanethiol, heptanethiol, octanethiol, nonanethiol, decanethiol, undecanethiol, dodecanethiol, octadecanethiol, 2-(2-methoxyethoxy)ethanethiol, 3-methoxybutyl 3-mercaptopropionate, 3-methoxybutylmercaptoacetate, thioglycolic acid, 3-mercaptopropionic acid, thiopronin, 2-mercaptopropionic acid, 2-mercaptopropionate, 2-mercaptoethanol, cysteamine, 1-thioglycerol, mercaptosuccinic acid, L-cysteine, dihydrolipoic acid, 2-(dimethylamino) ethanethiol, 5-mercaptomethyltetrazole, 2,3-dimercapto-1-propanol, glutathione, $m(PEG)_n$-SH, dialkyl (e.g., diethyl) dithiocarbamic acid or its salt (e.g., dialkyldithiocarbamate), etc. These may be used alone or in combination with each other.

Formula 1

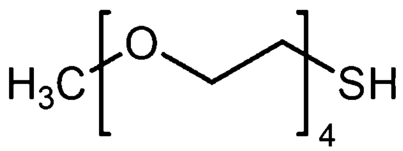

In one or more embodiments, the second ligand LD2 may be Mono(2-acryloyoxyethyl) Succinate, which includes carboxylate and acrylic. For example, the second ligand LD2 may include a compound represented by the following

formula 2.

For example, examples of materials that are included in the second ligand LD2 may include Zn, In, Ga, Mg, Ca, Sc, Sn, Ti, V, Cr, Mn, Fe, Co, Ni, Cu, Sr, Y, Zr, Nb, Mo, Cd, Ba, Au, Hg, Tl, divalent or higher metals, organometallic compounds, organometallic salts, inorganic metal salts/metal halides, metal alkyls, metal carboxylates, metal acetates, metal acrylates, metal methacrylates, metal dialkyldithiocarbamates, metal halides such as metal chlorides, metal bromides, metal iodides, zinc chloride, indium chloride, cadmium chloride, aluminium chloride, and iron chloride. The organometallic compound may include, for example, manganese chloride, zinc acetate, zinc acrylate, zinc diethyldithiocarbamate, indium acetate, metal halides, and/or organometallic compounds including relatively short organic functional groups, etc.

Formula 2

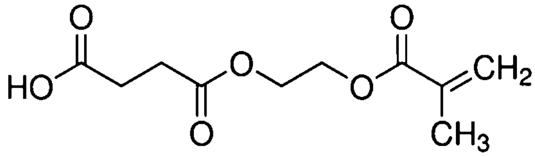

In one or more embodiments, a weight ratio of the first ligand LD1 and the second ligand LD2 may be about 1.5:1 to about 4:1. For example, a weight ratio of the first ligand LD1 and the second ligand LD2 may be about 2:1 to about 4:1. In one or more embodiments, a weight ratio of the first ligand LD1 and the second ligand LD2 may be 2:1 to about 3:1. However, embodiments of the present invention are not limited thereto. In one or more embodiments, a weight ratio of the quantum dot QD and the ligand LD may be about 1.5:1 to about 5:1. For example, a weight ratio of a sum of the weights of the first quantum dot QD1 and the second quantum dot QD2 and a sum of the weights of the first ligand LD1 and the second ligand LD2 is about 1.5:1 to about 5:1. In one or more embodiments, a weight ratio of the quantum dots QD and the ligand LD may be about 2:1 to about 4:1. For example, a weight ratio of the quantum dot QD and the ligand LD may be about 2:1 to about 3.5:1. However, embodiments of the present invention are not limited thereto.

FIG. 5 is a graph showing an example of a UV-vis absorption spectrum of each of first and second quantum dots of FIG. 3. FIG. 6 is a graph showing an example of a PL spectrum of each of the first and second quantum dots of FIG. 3. FIG. 7 is a graph showing an example of a UV-Vis absorption spectrum and a PL spectrum of each of the first quantum dot, the second quantum dot, and a mixture of the first and second quantum dots of FIG. 3. FIG. 8 is a graph for explaining a valley depth in a UV-Vis absorption spectrum of each quantum dot of FIG. 3. For example, FIG. 8 is a graph for explaining the valley depth in the UV-Vis absorption spectrum of the first quantum dot QD1.

Values on the vertical axis shown in FIGS. 5 to 8 are arbitrary portions a.u. since the portions represent only relative sizes.

FIGS. 5 and 6 show an example of light absorption and emission in the first quantum dot QD1 and the second quantum dot QD2 when light including a wavelength range of about 450 nm to about 460 nm is incident on each of the first quantum dot QD1 and the second quantum dot QD2.

In one or more embodiments, when light including a wavelength range of about 450 nm to about 460 nm is incident on the first quantum dot QD1, the first quantum dot QD1 may absorb the light and emit light at the same time. As shown in FIG. 7, when the first quantum dot QD1 is the quantum dot QD including InP, an area where the first quantum dot QD1 absorbs light and the first quantum dot emits light may overlap.

In one or more embodiments, when light including a wavelength range of about 450 nm to about 460 nm is incident on the second quantum dot QD2, the second quantum dot QD2 may absorb the light and emit light at the same time. As shown in FIG. 7, when the second quantum dot QD2 is the quantum dot QD including AIGS, an area where the second quantum dot QD2 absorbs light and the second quantum dot emits light may overlap.

In one or more embodiments, when the first quantum dot QD1 is the quantum dot QD including the first core CR1 including InP, and the second quantum dot QD2 is the quantum dot QD including the second core CR2 including AIGS, in a case when the first quantum dot QD1 and the second quantum dot QD2 are mixed together, the area where an absorption spectrum and a PL spectrum overlap may be reduced than the area where an absorption spectrum and a PL spectrum overlap of the second quantum dot QD2.

In one or more embodiments, when the first quantum dot QD1 is the quantum dot QD including the first core CR1 including InP, the first quantum dot QD1 may have a first absorption peak in an absorption spectrum. In one or more embodiments, when the second quantum dot QD2 is the quantum dot QD including the second core CR2 including AIGS, the second quantum dot QD2 may not include the first absorption peak in an absorption spectrum.

In one or more embodiments, a valley depth of an absorption spectrum of the first quantum dot QD1 may include a value greater than about 0 and less than about 1. In one or more embodiments, the valley depth of an absorption spectrum of the second quantum dot QD2 may include a value of 0. In one or more embodiments, the values of $Abs_{valley}$ and $Abs_{first}$ of

the second quantum dot QD2 are the same, so the valley depth value may be 0.

For example, the valley depth may satisfy Equation 1 below.

Equation 1

$$1 - (Abs_{valley}/Abs_{first}) = \text{valley depth}$$

Here, $Abs_{first}$ is an absorption at the first absorption peak, and $Abs_{valley}$ is an absorption at a lowest point of the valley adjacent to the first absorption peak.

Below, effects of embodiments of the present invention will be described with reference to examples and comparative examples.

**Preparation Example 1: InP/ZnSe/ZnS core-shell first quantum dot synthesis**

0.4 mmol (0.058 g) of indium acetate, 0.6 mmol (0.15 g) of palmitic acid, and 20 mL of 1-octadecene were provided to a reactor and heated to 120 °C under vacuum. After 1 hour, the atmosphere in the reactor was changed to nitrogen. After heating to 280 °C, a mixed solution of 0.2 mmol (58 μl) of tris(trimethylsilyl)phosphine (TMS3P) and 1.0 mL of trioctylphosphine was quickly injected thereto and allowed to react for 0.5 minutes.

Then, 2.4 mmoL (0.448 g) of zinc acetate, 4.8 mmol of oleic acid, and 20 mL of trioctylamine were added to the reactor and heated to 120 °C under vacuum. After 1 hour, the atmosphere in the reactor was changed to nitrogen, and the reactor was heated to 280 °C. 2 mL of the previously synthesized InP core solution was added, followed by 4.8 mmol of selenium (Se/TOP) in trioctylphosphine, and the final mixture was reacted for 2 hours. Ethanol was added to the resultant reaction solution quickly cooled to room temperature and centrifuged. The precipitate obtained was filtered under reduced pressure and dried under reduced pressure to form InP/ZnSe core-shell.

Next, 2.4 mmoL (0.448 g) of zinc acetate, 4.8 mmol of oleic acid, and 20 mL of trioctylamine were added to the reactor and heated to 120 °C under vacuum. After 1 hour, the atmosphere in the reactor was changed to nitrogen, and the reactor was heated to 280 °C. 2 mL of the previously synthesized InP core solution was added, followed by 4.8 mmol of sulfur in trioctylphosphine (S/TOP), and the final mixture was reacted for 2 hours. Ethanol was added to the resultant reaction solution quickly cooled to room temperature, centrifugation was performed, and the precipitate obtained was filtered under reduced pressure and dried under reduced pressure to obtain the first quantum dot having an InP/ZnSe/ZnS core-shell structure. The emission wavelength and half width of the obtained first quantum dot were 515 nm and 40 nm, respectively.

**Preparation Example 2: AgInGaS/GaS core-shell second quantum dot synthesis**

A mixed solution was prepared by adding 0.0625 mmol silver iodide (AgI, 99.999%), 1.25 mmol gallium acetylacetonate (Ga(acac)3, 99.99%) and 1 mmol sulfur (99.998%) to a three-neck flask, together with 1.5 ml 1-dodecanethiol (DDT≥98%) and 5 mL of oleyl amine (OLA, 70%). The mixed solution was heated to 120 °C and degassed, then purged with $N_2$ and grown at the growth temperature. The temperature was raised to 240 °C. AIGS cores were grown by maintaining this temperature for 30 minutes. 0.01 mmol of indium acetate (In(Ac)3, 99.99%) was added to this AIGS core solution. The resultant mixed solution was heated to 120 °C, degassed, and then $N_2$ purged and the temperature was raised to 240 °C, the growth temperature. AIGS cores were grown by maintaining this temperature for 10 minutes.

30 nmol of AIGS core was mixed together with 7 ml of oleyl amine, 0.1 mmol of gallium acetylacetonate (Ga(acac)3, 99.99%), and 0.1 mmol of 1,3-dimethyl-thiourea, and the temperature was rapidly raised to 230 °C. Under inert conditions, the temperature was increased by 2 °C per minute to 280 °C. The solution was cooled back to room temperature, and sulfur compounds that did not participate in the reaction were removed by degassing for 30 minutes. Afterwards, the reaction solution, which was quickly cooled to room temperature, was precipitated in ethanol, purified by centrifugation, and dried under reduced pressure to obtain a second quantum dot having an AgInGaS/GaS core-shell structure.

The obtained second quantum dot was diluted to 0.1 w% in a chloroform solution, and then the emission wavelength and half width were measured using QE-2100 (Otsuka Electronics). The emission wavelength and half width were measured and found to be 530 nm and 27 nm, respectively.

**Preparation Example 3: Synthesis of InP/ZnSe/ZnS core-shell first quantum dot, first ligand, and second ligand and synthesis of AgInGaS/GaS core-shell second quantum dot, first ligand, and second ligand**

As shown in Table 1 below, a first ligand and a second ligand were provided on the surface of each InP/ZnSe/ZnS core-shell first quantum dot formed through preparation Example 1 and the AgInGaS/GaS core-shell second quantum dot

formed through preparation Example 2.

The first ligand was formed using m$(PEG)_4$-SH, and the second ligand was formed using Mono(2-acryloyloxyethyl) Succinate.

Accordingly, the first quantum dot synthesized with the first ligand and the second ligand corresponds to the first quantum dot in FIG. 3, and the second quantum dot synthesized with the first ligand and the second ligand corresponds to the first quantum dot in FIG. 3.

As shown in Table 1 below, based on the total content of the composition of the light control portion (e.g., the first light control portion CCP1 in FIG. 2), the composition included 40 wt% of the quantum dot formed through Preparation Example 3, 4 wt% $TiO_2$, 55 wt% monomer, 1 wt% initiator. The monomer was a methacrylate monomer.

Accordingly, the color conversion layer (e.g., color conversion layer CCL of FIG. 2) was formed using the composition.

Table 1

| composition | content(wt%) |
|---|---|
| quantum dot | 40 wt% |
| $TiO_2$ | 4 wt% |
| monomer | 55 wt% |
| initiator | 1 wt% |

**<Examples 1 to 5, Comparative Examples 1 to 2>**

Table 2 below shows a table comparing the first quantum dots and the second quantum dots according to their weight ratio in the case that the first ligand including m$(PEG)_4$-SH and the second ligand including Mono(2-acryloyloxyethyl) Succinate mixed in a 1:1 weight ratio according to Examples 1 to 5. Comparative Example 1 measured the light absorption and external quantum efficiency of the first quantum dot alone, and Comparative Example 2 measured the light absorption and external quantum efficiency of the second quantum dot alone.

In Table 2 below, the InP-based material is a material that forms the first core included in the first quantum dot, and the AIGS-based material is a material that forms the second core included in the second quantum dot.

Referring to Table 2 below, in Examples 1 to 5, the first quantum dot and the second quantum dot were mixed together to form a single film of about 10 μm, and then light including a wavelength range of about 450 nm to about 460 nm was applied to the single film and the light absorption rate and external quantum efficiency were measured. In Comparative Example 1, after forming the first quantum dot into a single film of about 10 μm, light including a wavelength range of about 450 nm to about 460 nm was incident on the single film including the first quantum dot, and the light absorption rate and external quantum efficiency were measured. In Comparative Example 2, after forming the second quantum dot into a single film of about 10 μm, light including a wavelength range of about 450 nm to about 460 nm was incident on the single film including the second quantum dot, and the light absorption rate and external quantum efficiency were measured.

The single layer corresponds to light control portions (e.g., light control portions CCP1, CCP2, and CCP3 in FIG. 2) formed using the composition shown in Table 1 above.

As a result, referring to Table 2 below, in the single film satisfying Comparative Example 1, it can be seen that the light absorption rate was 84% and the external quantum efficiency was 34%. Additionally, in the single film satisfying Comparative Example 2, it can be seen that the light absorption rate was 92% and the external quantum efficiency was 25%.

Table 2

| | InP (Comparative Example 1) | AIGS(Comparative Example 2) | InP-based : AIGS-based | | | | |
|---|---|---|---|---|---|---|---|
| | | | 1:2 (Example 1) | 1:1 (Example 2) | 2:1 (Example 3) | 4:1 (Example 4) | 8:1 (Example 5) |
| light absorption rate | 84% | 92% | 88% | 87% | 87% | 85% | 85% |

(continued)

| | InP (Comparative Example 1) | AIGS(Comparative Example 2) | InP-based : AIGS-based | | | | |
|---|---|---|---|---|---|---|---|
| | | | 1:2 (Example 1) | 1:1 (Example 2) | 2:1 (Example 3) | 4:1 (Example 4) | 8:1 (Example 5) |
| external quantum efficiency | 34% | 25% | 30% | 31% | 38% | 36% | 34% |

In Example 1, in the case of the single film manufactured with a weight ratio of the first quantum dot and the second quantum dot of 1:2, it can be seen that the light absorption rate was 88% and the external quantum efficiency was 30%.

In Example 2, in the case of the single film manufactured with a weight ratio of the first quantum dot and the second quantum dot of 1:1, it can be seen that the light absorption rate was 87% and the external quantum efficiency was 31%.

In Example 3, in the case of the single film manufactured with a weight ratio of the first quantum dot and the second quantum dot of 2:1, it can be seen that the light absorption rate was 87% and the external quantum efficiency was 38%.

In Example 4, in the case of the single film manufactured with a weight ratio of the first quantum dot and the second quantum dot of 4:1, it can be seen that the light absorption rate was 85% and the external quantum efficiency was 36%.

In Example 5, in the case of the single film manufactured with a weight ratio of the first quantum dot QD1 and the second quantum dot QD2 of 8:1, it can be seen that the light absorption rate was 85% and the external quantum efficiency was 34%.

**Examples 6 to 10, Comparative Examples 3 to 4**

Table 3 below shows a table comparing the first ligand including $m(PEG)_4$-SH and the second ligand including Mono(2-acryloyloxyethyl) Succinate according to weight ratio in the case of mixing according to a weight ratio the first quantum dots including the first core including InP and the second quantum dots including the second core including AIGS according to Examples 6 to 10 at a weight ratio of 2:1.

In addition, Table 3 below shows that in the case where the first quantum dots including the first core including InP and the second quantum dots including the second core including AIGS were mixed according to a 2:1 weight ratio, Comparative Example 3, which compared the first ligand including $m(PEG)_4$-SH by mixing it alone, and Comparative Example 4, which compared the second ligand including Mono (2-acryloyloxyethyl) Succinate by mixing it alone.

Referring to Table 3 below, in Examples 6 to 10, the first quantum dots and the second quantum dots were mixed together at a weight ratio of 2:1 to form a single film of about 10 $\mu$m, and then a light of about 450 nm to about 460 nm was applied to the single film, then the light absorption rate and external quantum efficiency were measured. In Comparative Example 3, the first quantum dot and the second quantum dot were mixed together at a weight ratio of about 2:1 and the first ligand was added to form a first single layer of about 10 $\mu$m, and then light including a range of wavelengths of about 450 nm to about 460 nm was incident and the light absorption rate and external quantum efficiency were measured.

The single layer corresponds to light control portions (e.g., light control portions CCP1, CCP2, and CCP3 in FIG. 2) formed using the composition shown in Table 1 above.

As a result, referring to Table 3 below, in the single film in which the first quantum dot synthesized with the first ligand and the second quantum dot synthesized with the first ligand were mixed according to a weight ratio of 2:1 according to Comparative Example 3, it can be seen that the light absorption rate was 88% and the external quantum efficiency was 36%.

However, in Comparative Example 4, it was impossible to ink it alone and form a single film, so the light absorption rate and external quantum efficiency could not be measured.

Table 3

| | LD1 (Comparative Example 3) | LD2 (Comparative Example 4) | LD1: LD2 | | | | |
|---|---|---|---|---|---|---|---|
| | | | 3:1 (Example 6) | 2:1 (Example 7) | 1:1 (Example 8) | 1:2 (Example 9) | 1:3 (Example 10) |
| light absorption rate | 88% | X | 88% | 88% | 87% | 87% | 87% |
| external quantum efficiency | 36% | | 39% | 39% | 38% | 36% | 36% |

In Example 6, in the case of the single film prepared by using the first and second ligands at a weight ratio of 3:1, it can be seen that the light absorption rate was 88% and the external quantum efficiency was 39%.

In Example 7, it can be seen that a light absorption rate of 88% and an external quantum efficiency of 39% were exhibited in the case the single film manufactured with the first and second ligands at a weight ratio of 2:1.

In Example 8, it can be seen that a light absorption rate of 87% and an external quantum efficiency of 38% were exhibited in the case the single film manufactured with the first ligand and the second ligand at a weight ratio of 1:1.

In Example 9, it can be seen that a light absorption rate of 87% and an external quantum efficiency of 36% were exhibited in the case the single film manufactured with the first and second ligands at a weight ratio of 1:2.

In Example 10, it can be seen that a light absorption rate of 87% and an external quantum efficiency of 36% were exhibited by the single film manufactured with the first and second ligands at a weight ratio of 1:3.

As may be confirmed in Table 3, when the first quantum dot QD1 and the second quantum dot QD2 are mixed together at a weight ratio of 2:1, in the case the first ligand LD1 and the second ligand LD2 is a weight ratio of 2:1 or 3:1, it can be seen that the external quantum efficiency is maximized or increased.

As a result, when the color conversion layer is formed by mixing together the first quantum dot and the second quantum dot, the reabsorption re-excitation area rae of the UV-Vis absorption spectrum and a PL spectrum of the color conversion layer may be reduced. Specifically, when the first quantum dot and the second quantum dot are mixed together at a weight ratio of 2:1, the size of the reabsorption re-excitation area rae may be minimized or reduced.

While the present invention has been described with reference to embodiments, it will be understood by those skilled in the art that various modifications and changes may be made thereto without departing from the spirit and scope of the present invention as set forth in the following claims.

**[Industrial Applicability]**

The subject matter of the present invention may be applied to a display device and an electronic device including the same. For example, the present invention may be applied to high-resolution smartphones, mobile phones, smart pads, smart watches, tablet PCs, vehicle navigation systems, televisions, computer monitors, laptops, etc.

While the subject matter of the present invention has been particularly shown and described with reference to embodiments thereof, it will be understood by those of ordinary skill in the art that various changes in form and details may be made therein without departing from the spirit or scope of the invention as defined by the following claims, and equivalents thereof.

<Explanation of Reference Number>

| | | | |
|---|---|---|---|
| QD1: | a first quantum dot | QD2: | a second quantum dot |
| TL: | a transistor layer | TFE: | a film encapsulation layer |
| SUB1: | a first substrate | SUB2: | a second substrate |
| CR: | a core | LD: | a ligand |
| SH: | a shell | STL1, STL2: | first and second |
| BR: | a base resin | SC: | a scatterer |
| LED: | light emitting elements | CCP: | a light control portion |
| CCL: | a color conversion layer | CFL: | a color filter layer |
| DP: | a display panel | | |

**Claims**

1. A display device comprising:

   a light emitting element on a substrate and that generates light of a preset color; and
   a color conversion layer on the light emitting element and comprising a first quantum dot that emits a first absorption peak in a UV-vis absorption spectrum and a second quantum dot that is different from the first quantum dot and does not emit a first absorption peak in a UV-vis absorption spectrum.

2. The display device of claim 1, wherein a weight ratio of the first quantum dot to the second quantum dot is about 1.5:1 to about 2.5:1.

3. The display device of claim 1, wherein the first quantum dot comprises a first core comprising indium (In) and phosphorus (P).

4. The display device of claim 3, wherein the first quantum dot further comprises a first shell surrounding the first core, and
   the first shell comprises at least one selected from the group consisting of zinc (Zn), selenium (Se), and sulfur (S).

5. The display device of claim 1, wherein the second quantum dot comprises a second core comprising silver (Ag), indium (In), gallium (Ga), and sulfur (S).

6. The display device of claim 5, the second quantum dot further comprises a second shell surrounding the second core, and
   wherein the second shell comprises gallium (Ga) and sulfur (S).

7. The display device of claim 1, wherein a valley depth of the first quantum dot satisfying Equation 1 below includes a value greater than about 0 and less than about 1:

   Equation 1

   $$1 - (Abs_{valley}/Abs_{first}) = \text{valley depth}$$

   wherein, $Abs_{first}$ is an absorption at the first absorption peak, and $Absv_{alley}$ is an absorption at a lowest point of a valley adjacent to the first absorption peak.

8. The display device of claim 1, wherein a first radius of the first quantum dot is smaller than an exciton Bohr radius of the first quantum dot.

9. The display device of claim 1, wherein a second radius of the second quantum dot is larger than an exciton Bohr radius of the second quantum dot.

10. The display device of claim 1, wherein a maximum emission wavelength of a PL spectrum of the first quantum dot is about 495 nm to about 535 nm.

11. The display device of claim 1, wherein a maximum emission wavelength of a PL spectrum of the second quantum dot is about 515 nm to about 545 nm.

12. The display device of claim 1, wherein a maximum emission wavelength of a PL spectrum of the color conversion layer is about 511 nm to about 541 nm.

13. The display device of claim 1, wherein each of the first quantum dot and the second quantum dot comprises a first ligand and a second ligand different from the first ligand.

14. The display device of claim 13, wherein the first ligand comprises a compound comprising a thiol group and polyethylene glycol.

**15.** The display device of claim 13, wherein the second ligand comprises a compound comprising carboxylate and acrylic.

**16.** The display device of claim 13, wherein a weight ratio of the first ligand to the second ligand is about 1.5:1 to about 4:1.

**17.** The display device of claim 13, wherein a weight ratio of a sum of a weight of the first quantum dot and the second quantum dot to a sum of a weight of the first ligand and the second ligand is about 1.5:1 to about 5:1.

**18.** An electronic device comprising:

a display device comprising a substrate comprising a first pixel area, a second pixel area, and a third pixel area that emits light of different colors;
a light emitting element in each of the first, the second, the third pixel areas on the substrate and that generates a preset light;
a first light control portion in the first pixel area on the light emitting element and comprising a first quantum dot that exhibits a first absorption peak in a UV-vis absorption spectrum and a second quantum dot that does not exhibit a first absorption peak in a UV-vis absorption spectrum;
a second light control portion in the second pixel area on the light emitting element and comprising a same material as the first light control portion; and
a third light control portion in the third pixel area on the light emitting element; and
a power supply module that supplies power to the display device.

**19.** The electronic device of claim 18, wherein a weight ratio of the first quantum dot to the second quantum dot is about 1.5:1 to about 2.5:1.

**20.** The electronic device of claim 18, wherein the first quantum dot comprises a first core comprising indium (In) and phosphorus (P), and
the second quantum dot comprises a second core including silver (Ag), indium (In), gallium (Ga), and sulfur (S).

FIG. 1

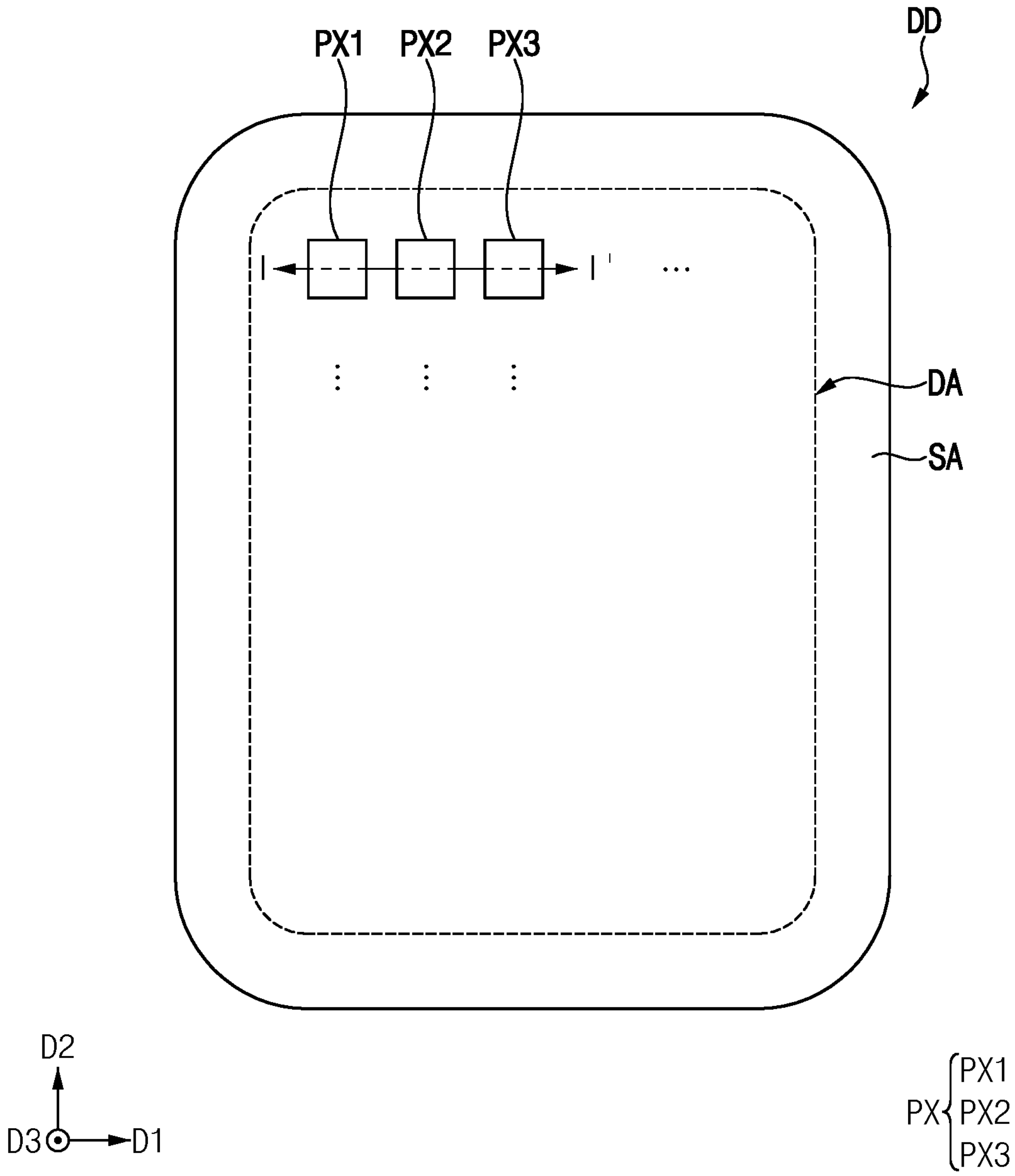

FIG. 2

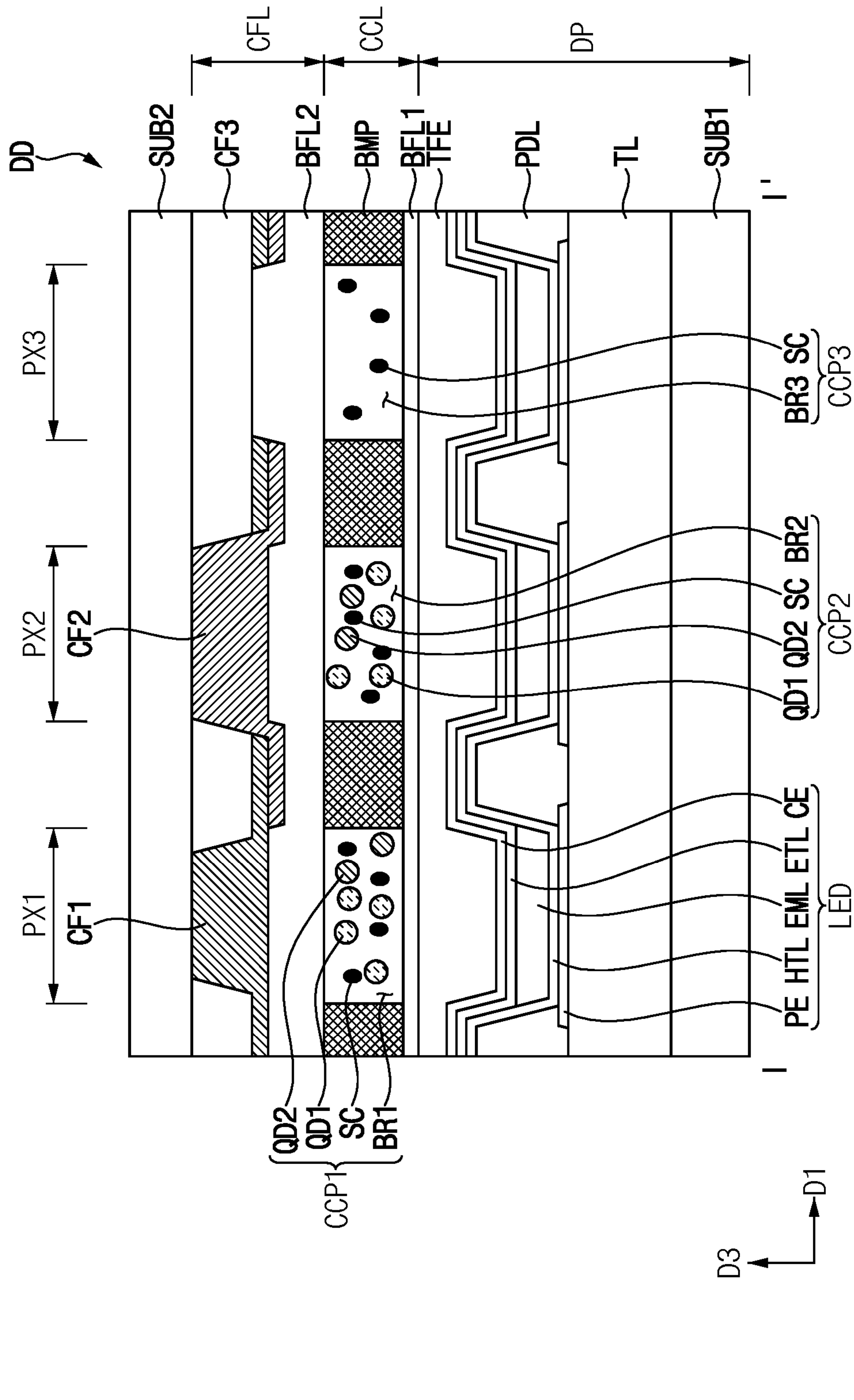

DD
CFL
CCL
DP
SUB2
CF3
BFL2
BMP
BFL1
TFE
PDL
TL
SUB1
I'
I
PX1
PX2
PX3
CF1
CF2
QD2
QD1
SC
BR1
CCP1
PE HTL EML ETL CE
LED
QD1 QD2 SC BR2
CCP2
BR3 SC
CCP3
D3
D1

FIG. 3

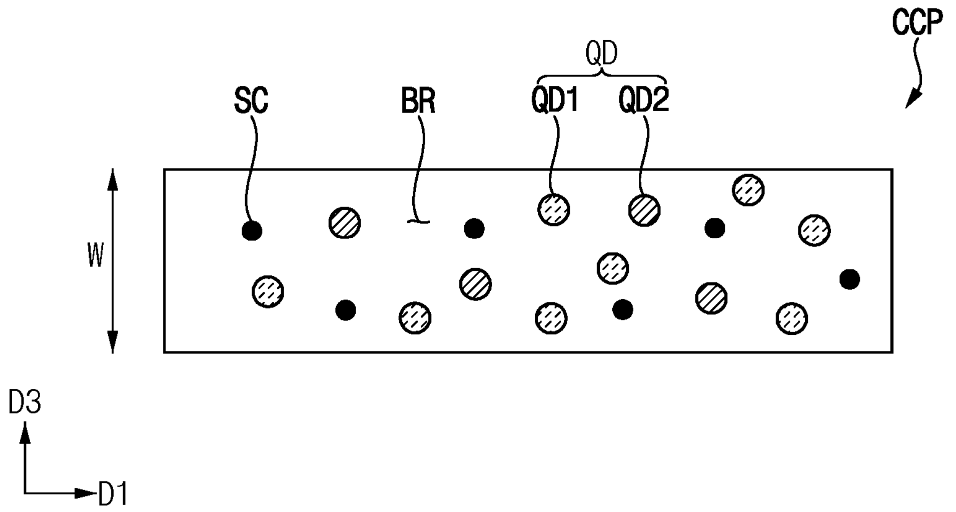
CCP
QD
SC
BR
QD1
QD2
W
D3
D1

FIG. 4

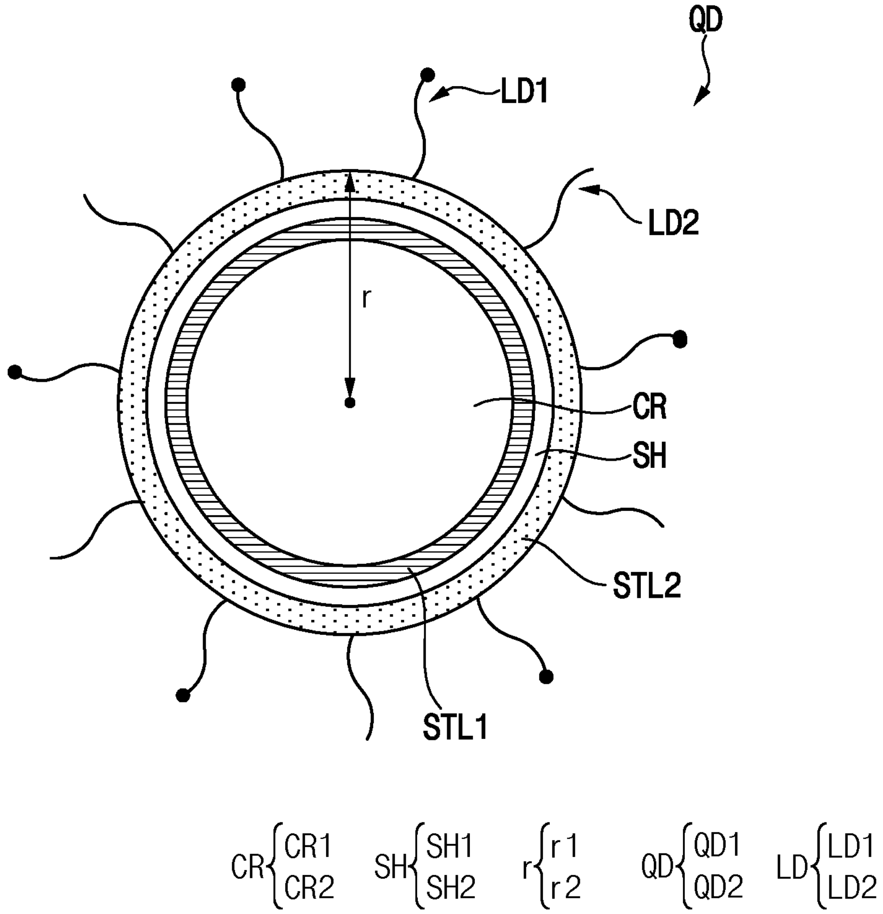
QD
LD1
LD2
r
CR
SH
STL2
STL1
CR{CR1 CR2
SH{SH1 SH2
r{r1 r2
QD{QD1 QD2
LD{LD1 LD2

FIG. 5

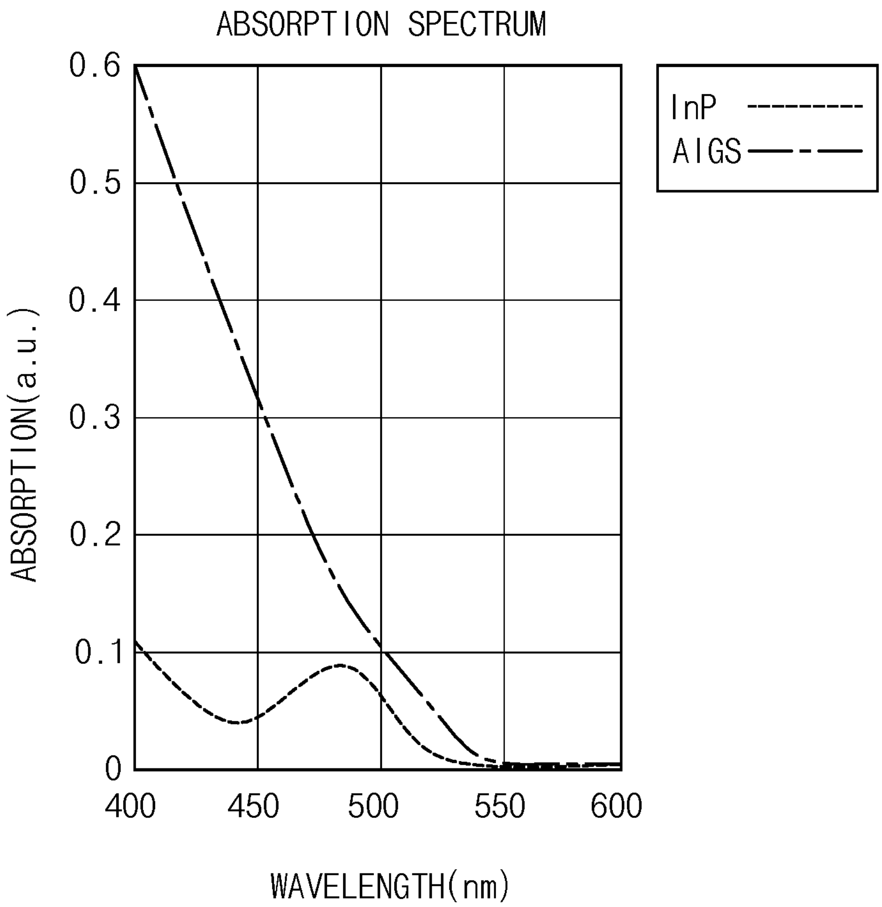
ABSORPTION SPECTRUM
ABSORPTION(a.u.)
0.6
0.5
0.4
0.3
0.2
0.1
0
400
450
500
550
600
WAVELENGTH(nm)
InP
AIGS

FIG. 6

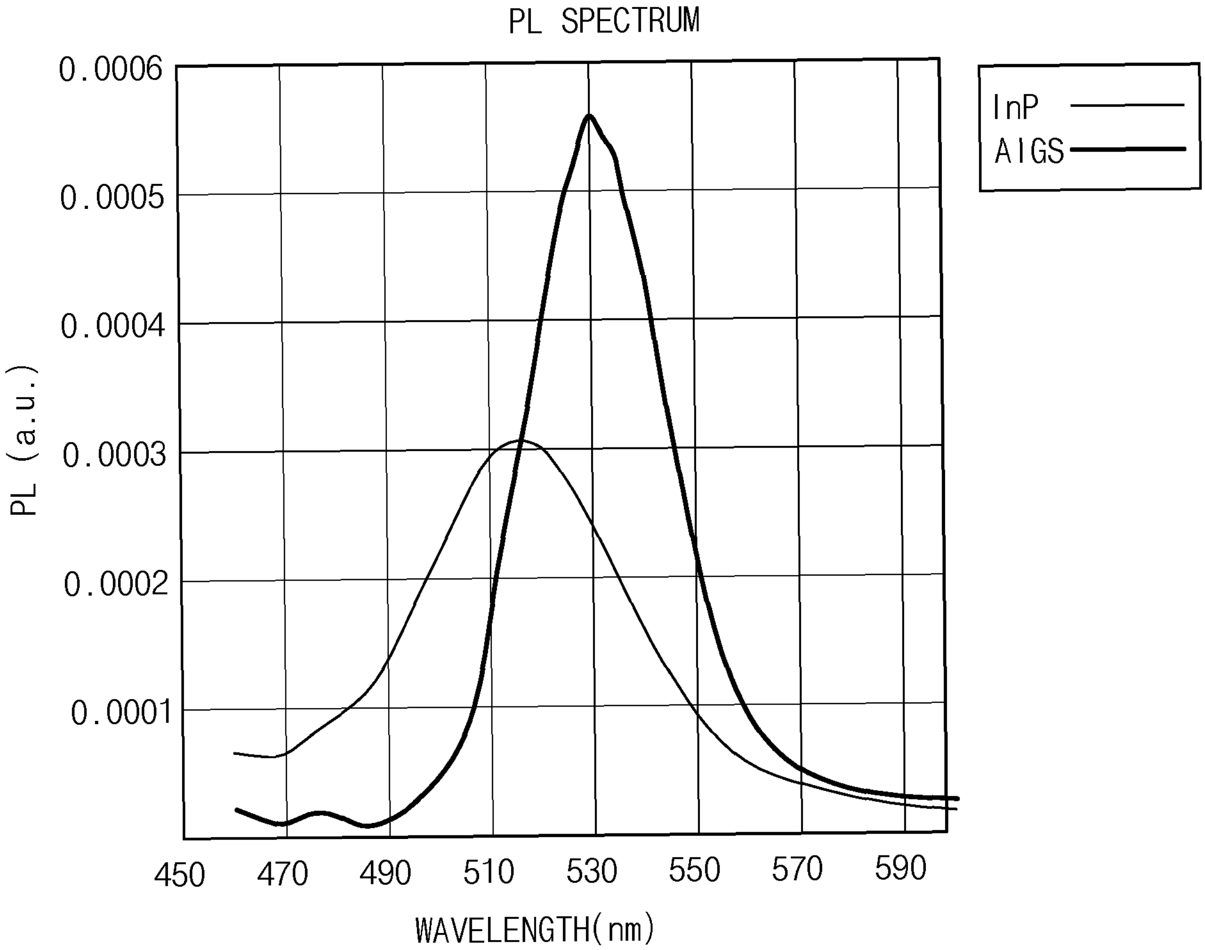
PL SPECTRUM
0.0006
0.0005
0.0004
0.0003
0.0002
0.0001
PL (a.u.)
450
470
490
510
530
550
570
590
WAVELENGTH(nm)
InP
AIGS

FIG. 7

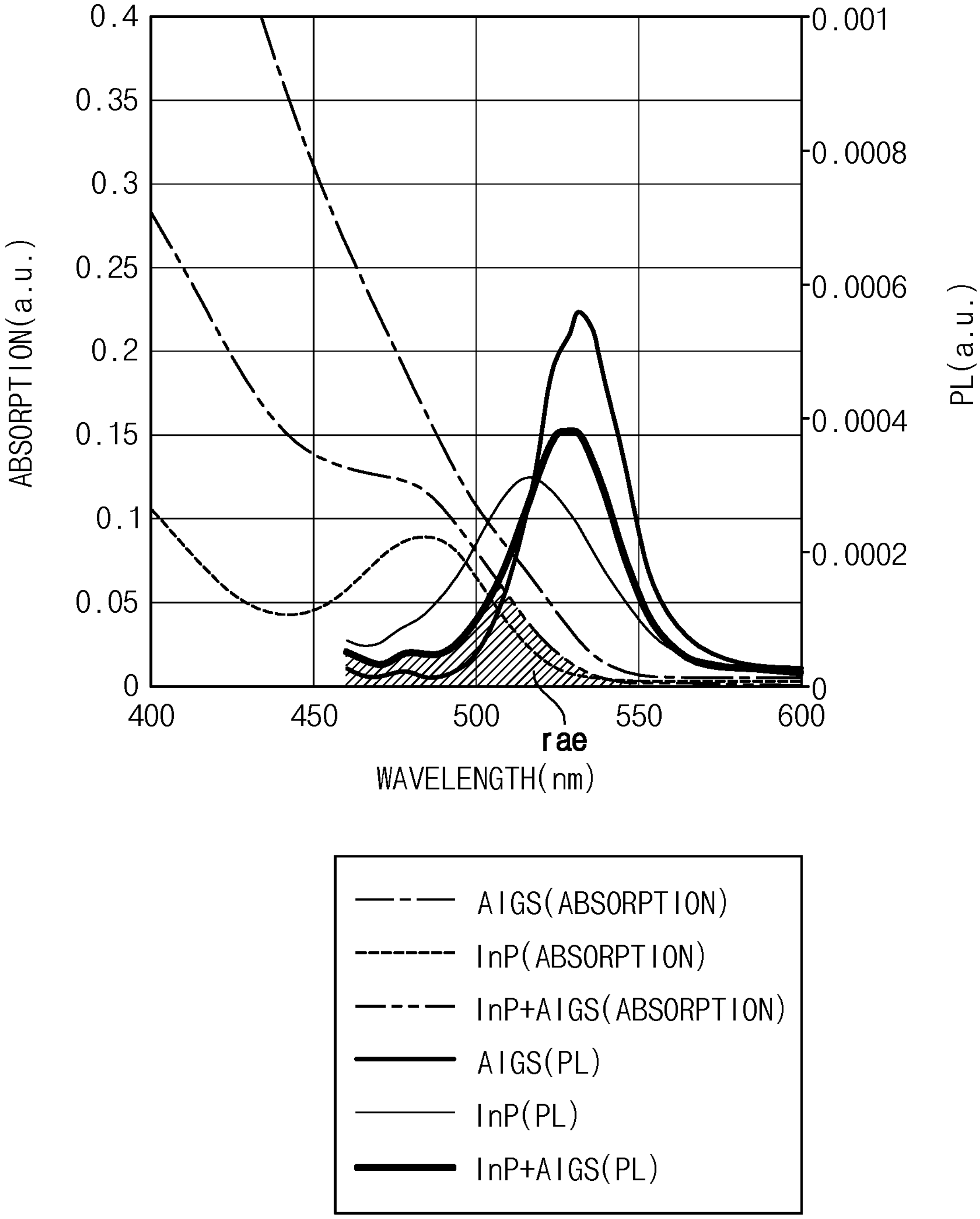
0.4
0.35
0.3
0.25
0.2
0.15
0.1
0.05
0
ABSORPTION(a.u.)
0.001
0.0008
0.0006
0.0004
0.0002
0
PL(a.u.)
400
450
500
550
600
rae
WAVELENGTH(nm)
AIGS(ABSORPTION)
InP(ABSORPTION)
InP+AIGS(ABSORPTION)
AIGS(PL)
InP(PL)
InP+AIGS(PL)

FIG. 8

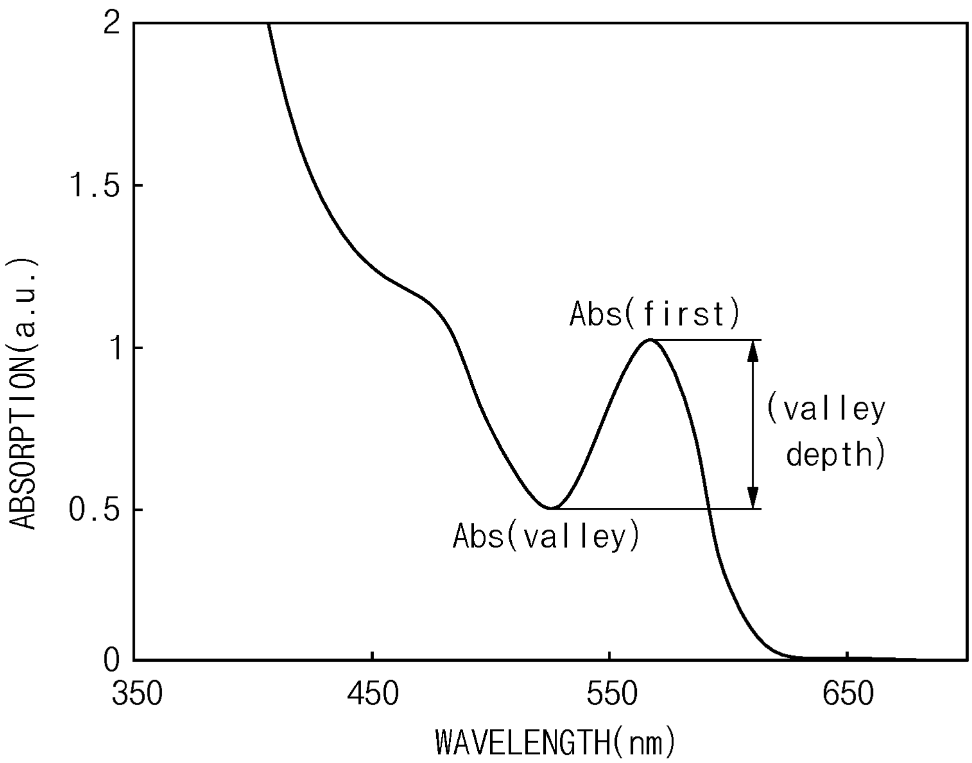
2
1.5
1
0.5
0
350
450
550
650
ABSORPTION(a.u.)
WAVELENGTH(nm)
Abs(first)
(valley
depth)
Abs(valley)

## INTERNATIONAL SEARCH REPORT

International application No.
**PCT/KR2024/014318**

**A. CLASSIFICATION OF SUBJECT MATTER**

**H10K 59/38**(2023.01)i; **H10K 59/35**(2023.01)i; **H10K 77/10**(2023.01)i; **H10K 59/90**(2023.01)i

According to International Patent Classification (IPC) or to both national classification and IPC

**B. FIELDS SEARCHED**

Minimum documentation searched (classification system followed by classification symbols)

H10K 59/38(2023.01); G02F 1/1335(2006.01); H01L 33/00(2010.01); H01L 33/50(2010.01); H10K 50/00(2023.01); H10K 50/80(2023.01); H10K 59/00(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 양자점(quantum dot), 리간드(ligand), 스펙트럼(spectrum), 밸리(valley), 색 변환 (color conversion)

**C. DOCUMENTS CONSIDERED TO BE RELEVANT**

| Category* | Citation of document, with indication, where appropriate, of the relevant passages | Relevant to claim No. |
|---|---|---|
| X<br>Y | KR 10-2021-0065245 A (SAMSUNG DISPLAY CO., LTD.) 04 June 2021 (2021-06-04)<br>See paragraphs [0070]-[0101] and figures 5-6a. | 1-9,18-20<br>10-17 |
| Y | KR 10-2023-0032644 A (SAMSUNG ELECTRONICS CO., LTD.) 07 March 2023 (2023-03-07)<br>See paragraphs [0062]-[0182] and claims 20-22. | 10-17 |
| A | KR 10-2022-0125630 A (SAMSUNG ELECTRONICS CO., LTD.) 14 September 2022 (2022-09-14)<br>See paragraphs [0173]-[0176] and claims 1-2 and 4. | 1-20 |
| A | KR 10-2021-0080923 A (LG DISPLAY CO., LTD.) 01 July 2021 (2021-07-01)<br>See paragraphs [0040]-[0042], claim 4 and figure 2. | 1-20 |
| A | KR 10-2023-0044654 A (SAMSUNG ELECTRONICS CO., LTD. et al.) 04 April 2023 (2023-04-04)<br>See paragraphs [0084]-[0096]. | 1-20 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 December 2024** | **19 December 2024** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**
**Information on patent family members**

International application No.
**PCT/KR2024/014318**

| Patent document cited in search report | Publication date (day/month/year) | Patent family member(s) | Publication date (day/month/year) |
|---|---|---|---|
| KR 10-2021-0065245 A | 04 June 2021 | CN 112863374 A | 28 May 2021 |
| | | US 11462595 B2 | 04 October 2022 |
| | | US 11985882 B2 | 14 May 2024 |
| | | US 2021-0159278 A1 | 27 May 2021 |
| | | US 2023-0005997 A1 | 05 January 2023 |
| KR 10-2023-0032644 A | 07 March 2023 | US 2023-0078393 A1 | 16 March 2023 |
| KR 10-2022-0125630 A | 14 September 2022 | CN 115011344 A | 06 September 2022 |
| | | US 2022-0283345 A1 | 08 September 2022 |
| KR 10-2021-0080923 A | 01 July 2021 | KR 10-2722259 B1 | 24 October 2024 |
| KR 10-2023-0044654 A | 04 April 2023 | KR 10-2687587 B1 | 22 July 2024 |
| | | US 2023-0139500 A1 | 04 May 2023 |

Form PCT/ISA/210 (patent family annex) (July 2022)